# EUROPÄISCHE PATENTSCHRIFT

(11) **EP 0 633 662 B1**
(45) Veröffentlichungstag und Bekanntmachung des Hinweises auf die Patenterteilung: **14.01.1998**
(21) Anmeldenummer: 94109989.7
(22) Anmeldetag: 28.06.1994
(51) Int. Cl.: H03K 3/03, H03K 3/354

(54) **Schaltungsanordnung für einen Ringoszillator**
Circuit arrangement for a ring oscillator
Montage pour un oscillateur en anneau

(30) Priorität: 07.07.1993 DE 4322701
(43) Veröffentlichungstag der Anmeldung: 11.01.1995
(73) Patentinhaber: SIEMENS AKTIENGESELLSCHAFT, 80333 München (DE)
(72) Erfinder: Feldtkeller, Martin, D-81543 München (DE)

(56) Entgegenhaltungen:
- EP-A- 0 189 571
- WO-A-94/26026
- US-A- 3 350 659
- US-A- 4 236 121
- US-A- 4 368 480
- PATENT ABSTRACTS OF JAPAN vol. 8, no. 58 (P-261) (1495) 16. März 1984 & JP-A-58 207 123 (TOKYO SHIBAURA DENKI K.K.) 2. Dezember 1983

## Beschreibung

Die Erfindung betrifft eine Schaltungsanordnung für einen Ringoszillator gemäß dem Oberbegriff des Patentanspruchs 1.

In integrierten Leistungsschaltungen werden zur Ansteuerung von Leistungs-MOS-Transistoren häufig Ladungspumpen verwendet. Damit die Ladungspumpe mit möglichst kleinen integrierten Kondensatoren auskommt, muß sie auf einer möglichst hohen Frequenz arbeiten. Dabei muß jedoch die elektromagnetische Abstrahlung beachtet werden.

Eine diesbetreffende Schaltungsanordnung ist aus der US-5 036 229 bekannt. Die US-Patentschrift schlägt dazu vor mehrere ineinander verschachtelte Signale zu generieren, wobei jeweils zwei Signale komplementär sind. Bei Betrachtung der in Figur 7 dargestellten Oszillatorschaltung zeigt sich jedoch, daß die vorgeschlagene Methode Signale erzeugt, die nicht genau komplementär sind, da sie durch Unsymmetrie um eine Inverterlaufzeit verschoben sind. Des weiteren können bei derartigen Anordnungen in den Treiberstufen Querströme im Schaltmoment entstehen. Dies führt zu unerwünschter elektromagnetischer Abstrahlung.

Eine gattungsgemäße Schaltungsanordnung ist auch aus US-4 236 121 sowie US-4 368 480 bekannt. Jeweils die Figuren 15 dieser Dokumente zeigen einen gattungsgemäßen Ringoszillator, der zwei Reihenschaltungen bestehend aus jeweils zwei Treiberstufen aufweist, wobei der Ausgang der letzten Treiberstufe der einen Reihenschaltung mit jeweils dem Eingang der ersten Treiberstufe der anderen Reihenschaltung verbunden ist. Desweiteren sind zwei Haltestufen vorgesehen, die jeweils zwischen den Ausgängen der zwei Treiberstufen der ersten und der zweiten Reihenschaltung geschaltet sind. An den Ausgängen der Treiberstufen der ersten Reihenschaltung sind die Ausgangssignale und an den Ausgängen der Treiberstufen der zweiten Reihenschaltung sind die invertierten Ausgangssignale des Ringoszillators abgreifbar.

Aus WO 94/26026 (Stand der Technik nach Art. 54(3) EPÜ) ist ein weiterer gattungsgemäßer Ringoszillator bekannt. Insbesondere in Figur 8 dieses Dokuments ist ein Oszillator, bestehend aus zwei synchronisierten Oszillatorringen beschrieben. Der Ringoszillator weist zwei Reihenschaltungen bestehend aus mehreren Invertern auf, wobei jeweils zwischen zwei Invertern der einen Reihenschaltung und jeweils zwei Invertern der anderen Reihenschaltung eine Haltestufe vorgesehen ist. Die Ausgänge der jeweiligen Inverterreihenschaltungen sind jeweils über kreuz mit den Eingängen der anderen Inverterreihenschaltung verbunden. Auf diese Weise erhält man jeweils zwei Signale an den Ausgängen der jeweiligen Inverterstufen, die genau komplementär um 180° zueinander verschoben verlaufen.

Aufgabe der vorliegenden Erfindung ist es, eine Generatorschaltung zur Erzeugung einer Anzahl von ineinander verschachtelten Signalen anzugeben, wobei jeweils zwei Signale genau komplementär zueinander verlaufen und die Flanken der Signale abgeflacht sein sollen.

Diese Aufgabe wird durch den kennzeichnenden Teil des Anspruchs 1 gelöst. Weiterbildungen sind in den abhängiger Ansprüchen gekennzeichnet.

Die Erfindung wird nachfolgend anhand von drei Figuren näher erläutert. Es zeigen
- Figur 1: ein prinzipielles Blockschaltbild einer erfindungsgemäßen Anordnung,
- Figur 2: eine Ausführungsform einer erfindungsgemäßen Anordnung gemäß Figur 1,
- Figur 3: der zeitliche Verlauf verschiedener in Figur 2 bezeichneter Signale.

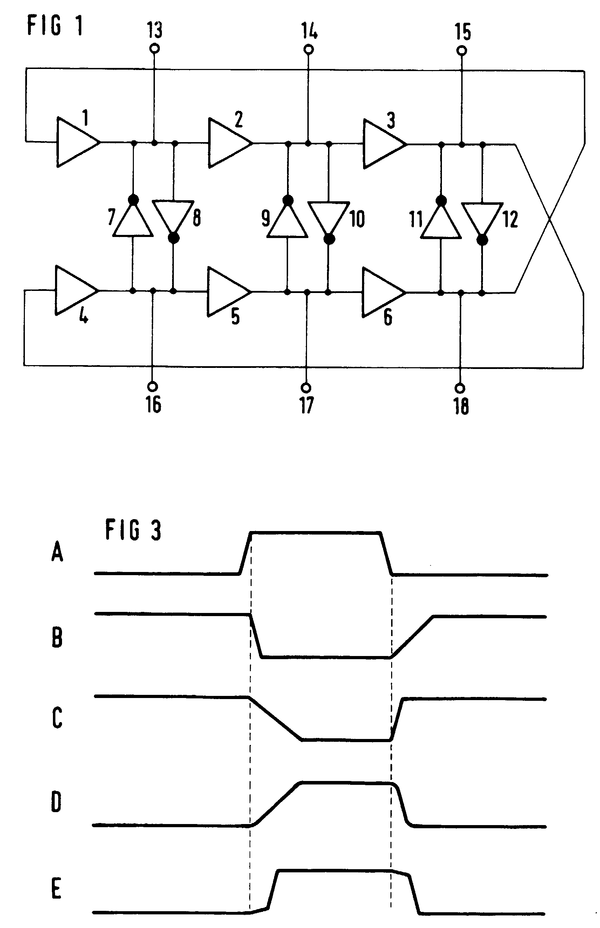

In Figur 1 sind drei Treiberstufen 1, 2, 3 dargestellt, die in einer ersten Reihenschaltung zusammengeschaltet sind. Ebenso ist eine zweite Reihenschaltung bestehend aus den drei Treiberstufen 4, 5, 6 vorgesehen. Der Eingang der Treiberstufe 1 ist mit dem Ausgang der Treiberstufe 6 verschaltet und der Ausgang der Treiberstufe 3 mit dem Eingang der Treiberstufe 4. Die Ausgänge der Treiberstufen 1, 2, 3 sind jeweils mit Anschlüssen 13, 14, 15 verbunden, an denen das Ausgangssignal der Schaltungsanordnung abgreifbar ist. Die Ausgänge der Treiberstufen 4, 5, 6 der zweiten Reihenschaltung sind jeweils mit Anschlüssen 16, 17, 18 verbunden, an denen die invertierten Ausgangssignale der Oszillatorschaltung abgreifbar sind. Zwischen den Ausgängen der Treiberstufe 1 und der Treiberstufe 4, sowie zwischen den Ausgängen der Treiberstufe 2 und der Treiberstufe 5, sowie zwischen den Ausgängen der Treiberstufe 3 und Treiberstufe 6 sind jeweils Haltestufen geschaltet. Diese Haltestufen bestehen jeweils aus zwei in zueinander entgegengesetzter Richtung parallel geschalteten Inverterstufen 7, 8 sowie 9, 10 und 11, 12.
Wie in Figur 1 gezeigt ist, besteht die Generatorschaltung im wesentlichen aus mindestens zwei symmetrisch aufgebauten Treiberstufen 1,4; 2,5; 3,6, die zu einem Laufzeitoszillator verkettet sind. Im dargestellten Beispiel in Figur 1 sind drei symmetrische Treiberstufen vorgesehen. Es können jedoch beliebig viele Treiberstufen hintereinander geschaltet werden je nachdem wie groß die Anzahl der benötigten Ausgangssignale ist.

Jede Oszillatorstufe besteht dabei aus zwei Treiberstufen 1,4; 2,5; 3,6 und aus jeweils zwei Invertern 7,8; 9,10; 11,12, die als Speicherelement aufgebaut sind und zwischen die Ausgänge der jeweiligen Oszillatorstufen geschaltet sind. Durch den spiegelsymmetrischen Aufbau einer Treiberstufe erhält auch das Speicherelement 7,8; 9,10; 11,12 zwei komplementäre Ausgangssignale von den jeweiligen Ausgängen der Treiberstufen 1,4; 2,5; 3,6, so daß die beiden Inverter nahezu zeitgleich ihren Zustand wechseln. Damit der Laufzeitoszillator schwingt, müssen die Leitungen zwischen den Ausgängen der jeweiligs letzten Treiberstufen 3,6 der Reihenschaltungen überkreuzt werden und mit den Eingängen, der Treiberstufe der jeweils anderen Reihenschaltung verbunden werden.

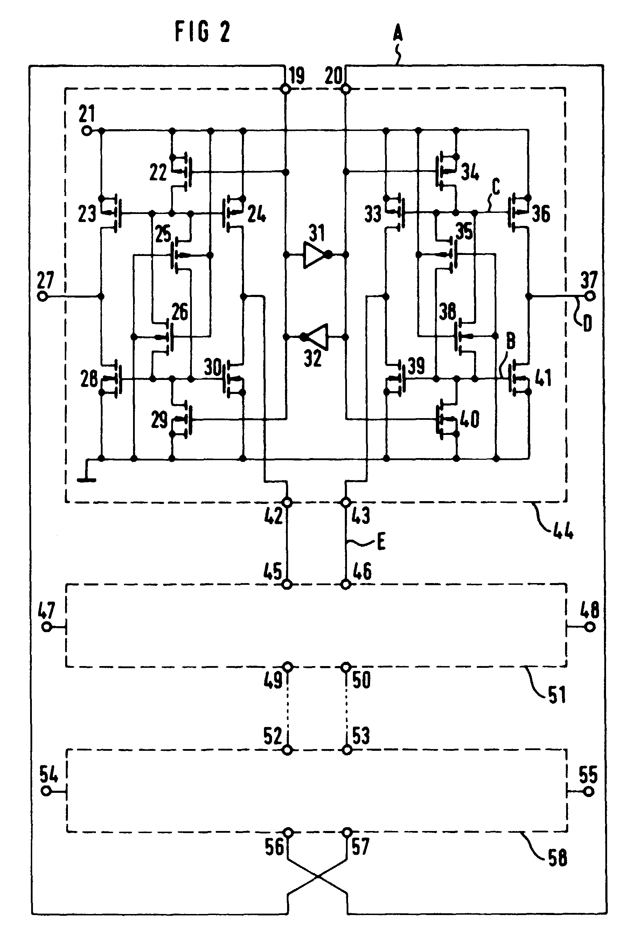

In Figur 2 ist mit 44 detailliert eine Oszillatorstufe der in Figur 1 dargestellten Oszillatorschaltung dargestellt, wobei eine Stufe beispielsweise aus den Treiberstufen 1 und 4 sowie den Haltestufen der vorgeschalteten Treiberstufen 11 und 12 bestehen kann. Mit 51 und 58 sind jeweils eine zweite und n-te Stufe schematisch dargestellt, wobei zwischen zweiter und n-ter Stufe eine beliebige Anzahl zusätzlicher Stufen vorgesehen sein kann. Die Eingänge der ersten Stufe sind mit 19 und 20 bezeichnet, die Ausgänge der ersten Stufe sind mit 42 und 43 bezeichnet. Ebenso sind die Eingänge der zweiten Stufe mit 45 und 46 sowie die Eingänge der n-ten Stufe mit 52 und 53 bezeichnet und die Ausgänge der zweiten Stufe mit 49 und 50 und die Ausgänge der n-ten Stufe mit 56 und 57 bezeichnet. Die Ausgangssignale der ersten, zweiten und n-ten Stufe können jeweils an Anschlüssen 37, 48 und 55 abgegriffen werden und die zugehörigen invertierten Ausgangssignale an den Anschlüssen 27, 47 und 54.

Die Eingangsklemme 19 ist zum einen mit dem Gateanschluß eines p-Kanal-FETS 22 und zum anderen mit dem Gateanschluß eines n-Kanal-FETS 29 verbunden. Des weiteren ist die Eingangsklemme 19 mit dem Eingang einer Inverterstufe 31 und dem Ausgang einer Inverterstufe 32 verschaltet. Eine Versorgungsspannungsklemme 21 ist vorgesehen, die mit dem Sourceanschluß des p-Kanal-FETS 22 sowie den Sourceanschlüssen eines p-Kanal-FETS 23 und eines p-Kanal-FETS 24 verbunden sind. Der Gateanschluß des p-Kanal-FETS 23 ist mit dem Drainanschluß des p-Kanal-FETS 22 und dem Gateanschluß des p-Kanal-FETS 24 verbunden. Desweiteren ist er mit dem Sourceanschluß eines p-Kanal-FETS 25 und dem Drainanschluß eines n-Kanal-FETS 26 verschaltet. Der Drainanschluß des p-Kanal-FETS 23 ist mit einem Ausgangsanschluß 27 und dem Drainanschluß eines n-Kanal-FETS 28 verbunden. Der Gateanschluß eines n-Kanal-FETS 28 ist mit dem Gateanschluß des n-Kanal-FETS 30 sowie dem Sourceanschluß des n-Kanal-FETS 26 und den Drainanschlüssen des n-Kanal-FETS 29 und des p-Kanal-FETS 25 verschaltet. Die Sourceanschlüsse der n-Kanal-FETS 28, 29 und 30 sind mit einem Bezugspotential z.B. Masse verschaltet. Ebenso ist der Gateanschluß des p-Kanal-FETS 25 und der Bulkanschluß des n-Kanal-FETS 26 mit Masse verschaltet. Der Gateanschluß des n-Kanal-FETS 26 und der Bulkanschluß des p-Kanal-FETS 25 sind mit der Versorgungsspannungsklemme 21 verbunden. Der Drainanschluß des p-Kanal-FETS 24 ist zum einen mit der Ausgangsklemme 42 und zum anderen mit dem Drainanschluß des n-Kanal-FETS 30 verbunden.

Die Eingangsklemme 20 ist zum einen mit dem Ausgangsanschluß der Treiberstufe 31 und mit dem Eingangsanschluß der Treiberstufe 32 sowie den Gateanschlüssen eines p-Kanal-FETS 34 und eines n-Kanal-FETS 40 verbunden. Die Sourceanschlüsse eines p-Kanal-FETS 33 und eines p-Kanal-FETS 36 sowie des p-Kanal-FETS 34 sind mit der Versorgungsspannungsklemme verbunden. Die Gateanschlüsse der p-Kanal-FETS 33 und 36 sind miteinander und mit dem Drainanschluß des p-Kanal-FETS 34 verschaltet. Desweiteren sind sie mit dem Sourceanschluß eines p-Kanal-FETS 35 und dem Drainanschluß eines n-Kanal-FETS 38 verschaltet. Der Drainanschluß des p-Kanal-FETS 33 ist mit einer Ausgangsklemme 43 und mit dem Drainanschluß eines n-Kanal-FETS 39 verschaltet. Der Drainanschluß des p-Kanal-FETS 36 ist mit der Ausgangsklemme 37 und mit dem Drainanschluß eines n-Kanal-FETS 41 verschaltet. Die Gateanschlüsse der n-Kanal-FETS 39 und 41 sind miteinander und mit dem Drainanschluß eines n-Kanal-FETS 40 verschaltet. Desweiteren sind sie mit dem Drainanschluß des p-Kanal-FETS 35 und dem Sourceanschluß des n-Kanal-FETS 38 verschaltet. Die Sourceanschlüsse der n-Kanal-FETS 39, 40, 41 sind mit dem Bezugspotential verbunden. Der Gateanschluß des p-Kanal-FETS 35 ist mit dem Bulkanschluß des n-Kanal-FETS 38 und mit Masse verschaltet. Der Gateanschluß des n-Kanal-FETS 38 ist mit dem Bulkanschluß des p-Kanal-FETS 35 und der Versorgungsspannungsklemme 21 verbunden.

Die Haltestufe wird durch die Inverter 31 und 32 gebildet. Eine Treiberstufe wird jeweils aus den FETS 33...41 bzw. 22...30 gebildet. Eine derartige Treiberstufe enthält eine Ausgangsstufe bestehend aus den Feldeffekttransistoren 36 und 41 (bzw. 23, 28), die über die p-Kanal-FETs 34 und 35 sowie die n-Kanal-FETs 38 und 40 angesteuert werden, so daß jeweils das Gate des abzuschaltenden FETS schneller entladen wird als das Gate des einzuschaltenden FETS aufgeladen wird. Das Entladen des Gates der Feldeffekttransistoren 36 und 41 geschieht über die FETS 34 bzw. 40, das Aufladen der Gates jeweils über die FETS 35 und 38. Die FETS 35 und 38 können theoretisch auch durch einen Widerstand ersetzt werden.

Die Ausgangsstufe 36, 41 bzw. 33, 39 schaltet somit querstromfrei und mit langsamen Flanken.

Wie oben beschrieben, erhält die Ausgangsstufe 33, 39; 24, 30 die gleichen Ansteuersignale wie die Ausgangsstufe 36, 41; 23, 28. Der Ausgang dieser Stufe 33, 39; 24, 30 ist mit dem Speicherelement der nachfolgenden Stufe 51 verbunden. Erst wenn das Gate von FET 36; 23 bzw. FET 41; 28 vollständig aufgeladen ist, ist auch der FET 33; 24 bzw. FET 39; 30 im Stande den Zustand des nachfolgenden Speicherelements zu verändern.

Figur 3 zeigt den zeitlichen Verlauf verschiedener Signale der in der Figur 2 dargestellten Schaltung. So ist mit A das Signal an der Eingangsklemme 20, mit B der Signalverlauf am Gate des FETS 41, mit C der Signalverlauf am Gate des FETS 36, mit D der Signalverlauf an der Ausgangsklemme 37 und mit E der Signalverlauf am Ausgang der Treiberstufe an der Ausgangsklemme 43 bezeichnet.

Dabei ist insbesondere herzuheben, daß durch die verwendete Anordnung Flanken des Ausgangssignales D abgeflacht sind, was zu einer verringerten elektromagnetischen Abstrahlung beiträgt.

## Patentansprüche

1. Schaltungsanordnung für einen Ringoszillator, mit einer ersten Reihenschaltung von n Treiberstufen (1, 2, 3) und einer zweiten Reihenschaltung von weiteren n Treiberstufen (4, 5, 6), wobei der Ausgang der letzten Treiberstufe (3, 6) einer Reihenschaltung mit jeweils dem Eingang der ersten Treiberstufe (1, 4) der anderen Reihenschaltung verbunden ist und n Haltestufen (7,8; 9,10; 11,12) vorgesehen sind, die jeweils zwischen den Ausgängen der n Treiberstufen der ersten und zweiten Reihenschaltung geschaltet sind und wobei an den Ausgängen der Treiberstufen der ersten Reihenschaltung die Ausgangssignale und an den Ausgängen der Treiberstufen der zweiten Reihenschaltung die invertierten Ausgangssignale des Ringoszillators abgreifbar sind,
**dadurch gekennzeichnet,** daß eine Treiberstufe
- zwei komplementäre Transistoren (23, 28; 36, 41) aufweist, deren Laststrecken zwischen einer Versorgungsspannung (21) und Masse in Reihe geschaltet sind,
- am Knotenpunkt der Reihenschaltung das Ausgangssignal der Treiberstufe abgreifbar ist,
- zwischen Versorgungsspannung (21) und Steueranschluß des mit der Versorgungsspannung verbundenen Transistors (23; 36) die Laststrecke eines dritten Transistors (22; 34) geschaltet ist, dessen Steueranschluß mit dem Eingangssignal (19; 20) der Treiberstufe beaufschlagt wird,
- zwischen Masse und Steueranschluß des mit Masse verbundenen Transistors (28; 41) die Laststrecke eines vierten Transistors (29; 40) geschaltet ist, dessen Steueranschluß mit dem Eingangssignal (19; 20) der Treiberstufe beaufschlagt wird,
- zwischen den Steueranschlüssen der in Reihe geschalteten Transistoren (23; 28) wenigstens ein Widerstand (25, 26; 35, 38) geschaltet ist,
- parallel zur ersten Reihenschaltung (23, 28; 36, 41) eine zweite Reihenschaltung zweier komplementärer Transistoren (24, 30; 33, 39) geschaltet ist, wobei deren Steueranschlüsse jeweils mit den Steueranschlüssen der entsprechenden Transistoren (23, 28; 36, 41) der ersten Reihenschaltung verbunden sind und wobei am Knotenpunkt der zweiten Reihenschaltung das Ausgangssignal (42; 43) des Ringoszillators abgreifbar ist.

2. Schaltungsanordnung nach Anspruch 1,
**dadurch gekennzeichnet,** daß anstelle eines Widerstandes die Laststrecken eines siebten und achten Transistors (25, 26; 35, 38) geschaltet sind, die komplementär zueinander sind, wobei der Steueranschluß des einen mit Masse und der Steueranschluß des anderen mit der Versorgungsspannung verbunden ist.

3. Schaltungsanordnung nach Anspruch 1 oder 2,
**dadurch gekennzeichnet**, daß die Transistoren Feldeffekttransistoren sind.

4. Schaltungsanordnung nach Anspruch 3 in Verbindung mit 2,
**dadurch gekennzeichnet,** daß der Bulkanschluß des siebten Transistors (25; 35) mit der Versorgungsspannung und der Bulkanschluß des achten Transistors (26; 38) mit Masse verbunden ist.

## Claims

1. Circuit arrangement for a ring oscillator, having a first series circuit formed by n driver stages (1, 2, 3) and having a second series circuit formed by further n driver stages (4, 5, 6), the output of the last driver stage (3, 6) of a series circuit being connected to the respective input of the first driver stage (1, 4) of the other series circuit, and provision being made of n holding stages (7, 8; 9, 10; 11, 12), which are each connected between the outputs of the n driver stages of the first and second series circuits, and it being possible to pick off the output signals of the ring oscillator at the outputs of the driver stages of the first series circuit and the inverted output signals of the ring oscillator at the outputs of the driver stages of the second series circuit, characterized in that a driver stage
- has two complementary transistors (23, 28; 36, 41), the load paths of which are connected in series between a supply voltage (21) and earth,
- the output signal of the driver stage can be picked off at the junction point of the series circuit,
- the load path of a third transistor (22; 34), to the control terminal of which the input signal (19; 20) of the driver stage is applied, is connected between the supply voltage (21) and control terminal of the transistor (23; 36) connected to the supply voltage,
- the load path of a fourth transistor (29; 40), to the control terminal of which the input signal (19; 20) of the driver stage is applied, is connected between earth and the control terminal of the transistor (28; 41) connected to earth,
- at least one resistor (25, 26; 35, 38) is connected between the control terminals of the transistors (23; 28) connected in series
- connected in parallel with the first series circuit (23, 28; 36, 41) is a second series circuit formed by two complementary transistors (24, 30; 33, 39), the control terminals of which are each connected to the control terminals of the corresponding transistors (23, 28; 36, 41) of the first series circuit, and it being possible to pick off the output signal (42; 43) of the ring oscillator at the junction point of the second series circuit.

2. Circuit arrangement according to Claim 1, characterized in that the load paths of a seventh and eighth transistor (25, 26; 35, 38), which are complementary to one another, are connected instead of a resistor, the control terminal of one of these transistors being connected to earth and the control terminal of the other transistor being connected to the supply voltage.

3. Circuit arrangement according to Claim 1 or 2, characterized in that the transistors are field-effect transistors.

4. Circuit arrangement according to Claim 3 in connection with 2, characterized in that the bulk terminal of the seventh transistor (25; 35) is connected to the supply voltage and the bulk terminal of the eighth transistor (26; 38) is connected to earth.

## Revendications

1. Montage pour un oscillateur en anneau, comprenant un premier circuit série de n étages d'attaque (1, 2, 3) et un second circuit série de n autres étages d'attaque (4, 5, 6), dans lequel la sortie du dernier étage d'attaque (3, 6) d'un circuit série est reliée à l'entrée du premier étage d'attaque (1, 4) de l'autre circuit série, dans lequel il est prévu n étages de maintien (7, 8 ; 9, 10 ; 11, 12) qui sont branchés respectivement entre les sorties des n étages d'attaque du premier et du second circuits série et dans lequel les signaux de sortie de l'oscillateur en anneau peuvent être prélevés aux sorties des étages d'attaque du premier circuit série et les signaux de sortie inversés de l'oscillateur en anneau peuvent être prélevés aux sorties des étages d'attaque du second circuit série,
caractérisé par le fait que
- un étage d'attaque comporte deux transistors complémentaires (23, 28 ; 36, 41) dont les voies de charge sont branchées en série entre une tension d'alimentation (21) et la masse,
- le signal de sortie de l'étage d'attaque peut être prélevé au noeud du circuit série,
- la voie de charge d'un troisième transistor (22 ; 34), dont la borne de commande reçoit le signal d'entrée (19 ; 20) de l'étage d'attaque, est branchée entre la tension d'alimentation (21) et la borne de commande du transistor (23 ; 36) relié à la tension d'alimentation,
- la voie de charge d'un quatrième transistor (29 ; 40), dont la borne de commande reçoit le signal d'entrée (19 ; 20) de l'étage d'attaque, est branchée entre la masse et la borne de commande du transistor (28 ; 41) relié à la masse,
- au moins une résistance (25, 26 ; 35, 38) est branchée entre les bornes de commande des transistors (23 ; 28) branchés en série,
- un second circuit série de deux transistors complémentaires (24, 30 ; 33, 39) est branché parallèlement au premier circuit série (23, 28 ; 36, 41), les bornes de commande de ces transistors complémentaires étant reliées respectivement aux bornes de commande des transistors correspondants (23, 28 ; 36, 41) du premier circuit série et le signal de sortie (42 ; 43) de l'oscillateur en anneau pouvant être prélevé au noeud du second circuit série.

2. Montage selon la revendication 1,
caractérisé par le fait que les voies de charge d'un septième et d'un huitième transistors (25, 26 ; 35, 38), qui sont complémentaires l'un de l'autre, sont branchées à la place d'une résistance, la borne de commande de l'un de ces transistors étant reliée à la masse et la borne de commande de l'autre transistor étant reliée à la tension d'alimentation.

3. Montage selon la revendication 1 ou 2,
caractérisé par le fait que les transistors sont des transistors à effets de champ.

4. Montage selon la revendication 3 en relation avec la revendication 2,
caractérisé par le fait que la borne bulk du septième transistor (25 ; 35) est reliée à la tension d'alimentation et la borne bulk du huitième transistor (26 ; 38) est reliée à la masse.
